**Europäisches Patentamt**

**European Patent Office**

**Office européen des brevets**

(19)

(11) Veröffentlichungsnummer: **0 115 803**
**A2**

(12) **EUROPÄISCHE PATENTANMELDUNG**

(21) Anmeldenummer: **84100622.4**

(22) Anmeldetag: **20.01.84**

(51) Int. Cl.³: **H 01 L 31/02, H 01 L 31/06**

(30) Priorität: **05.02.83 DE 3303926**

(43) Veröffentlichungstag der Anmeldung: **15.08.84**
**Patentblatt 84/33**

(84) Benannte Vertragsstaaten: **BE FR GB NL**

(71) Anmelder: **TELEFUNKEN electronic GmbH, Theresienstrasse 2, D-7100 Heilbronn (DE)**

(72) Erfinder: **Pschunder, Willi, Im Ring 43, D-7129 Ilsfeld (DE)**

(74) Vertreter: **Maute, Hans-Jürgen, Dipl.-Ing., TELEFUNKEN electronic GmbH Theresienstrasse 2, D-7100 Heilbronn (DE)**

(54) **Scheibenförmige Solarzelle.**

(57) Die Erfindung betrifft eine scheibenförmige Solarzelle mit einem Rückseitenkontakt und mit einem Leitbahnsystem als Vorderseitenkontakt, wobei an dieses Leitbahnsystem zur Verschaltung der Solarzellen mit weiteren Solarzellen mindestens ein metallischer Verbinder angeschlossen ist. Die Erfindung besteht darin, dass der oder die Verbinder an mehreren voneinander beabstandeten Stellen mit der oder den Leitbahnen elektrisch leitend und mechanisch fest derart verbunden sind, dass beim Aufteilen der Solarzelle in mehrere kleinere Solarzellen jede einzelne Solarzelle bereits mit mindestens einem, über den Scheibenrand hinausragenden Verbinder versehen ist.

0115803

TELEFUNKEN electronic GmbH
Theodor-Stern-Kai 1, 6000 Frankfurt 70


Heilbronn, den 18.01.83
PTL-HN-Ma-ra - HN 82/34


Scheibenförmige Solarzelle

Die Erfindung betrifft eine scheibenförmige Solarzelle nach den Merkmalen im Oberbegriff des Patentanspruches 1. Beim Zusammenbau von einzelnen Solarzellen zu Solarzellengeneratoren müssen die einzelnen Solarzellen elektrisch parallel oder in Reihe geschaltet werden. Hierzu werden die Solarzellen vor dem Zusammenbau des Generators mit metallischen Verbindern versehen, die beispielsweise an das Leitbahnnetz auf der für den Lichteinfall vorgesehenen Oberflächenseite der Halbleiterscheibe angeschlossen werden. Diese Verbinder bestehen vorzugsweise aus bandförmigen Metallstreifen, die beispielsweise aus Aluminium oder Kupfer bestehen. Diese Verbinder werden an einem Ende mit dem Leitbahnnetz der Solarzelle elektrisch und mechanisch fest so verbunden, daß das freie Ende des Verbinders über den Scheibenrand hinausragt und folglich mit dem Anschlußkontakt einer nachfolgenden Solarzelle elektrisch leitend verbunden werden kann.

- 2 -

0115803

Der Erfindung liegt die Aufgabe zugrunde, eine scheibenförmige Solarzelle anzugeben, aus der sich im Bedarfsfall bei gleichzeitiger Rationalisierung des Arbeitsablaufes kleinere Solarzellen gewinnen lassen. Diese Aufgabe wird mit den Merkmalen im Patentanspruch 1 gelöst.

Nach der Erfindung wird somit eine großflächige Solarzelle mit metallischen Verbindern versehen, die für die Verschaltung der großflächigen Solarzellen untereinander geeignet sind. Diese Verbinder sind aber gleichzeitig so ausgestaltet, daß beim Aufteilen der großflächigen Solarzelle in mehrere kleinere Solarzellen jede kleinere Solarzelle wiederum mit einem geeigneten Verbinder versehen ist, der über den Scheibenrand hinausragt und mit dem Kontakt einer anderen Solarzelle elektrisch leitend verbunden werden kann.

Für die Erfindung sind mehrere Ausführungsmöglichkeiten denkbar. Wesentlich ist, daß die Verbinder bei der Befestigung auf der großflächigen Solarzelle so ausgestaltet werden, daß ein Verbinder oder ein Verbinderteil beim Auftrennen der Halbleiterscheiben an den möglichen Trennstellen über den durch die Trennung entstehenden Scheibenrand hinausragt. Es ist beispielsweise möglich, an den Leitbahnen zahlreiche Verbinderteilstücke anzubringen, die in einer Reihe liegend angeordnet und nur mit einem Ende an der Leitbahn befestigt sind. Das freistehende Ende kann dann das in der Reihe vorangehende Verbinderteilstück schuppenförmig überlappen. Das freie Ende kann aber auch nur an das in der Reihe vorangehende Verbinderteilstück angrenzen ohne dieses zu überlappen, wenn die Trennstellen so gelegt werden, daß dieses freistehende Ende nach der Aufteilung der Halbleiterscheibe über den Scheibenrand hinausragt.

- 3 -

0115803

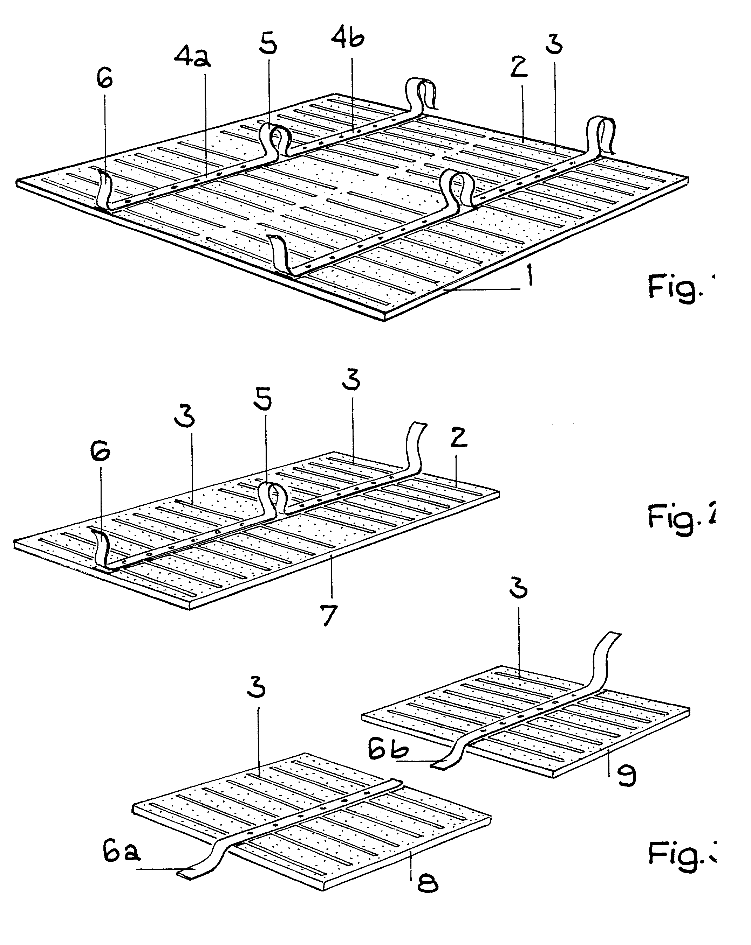

Die Erfindung und ihre weitere Ausgestaltung soll noch anhand von Ausführungsbeispielen näher erläutert werden. Die Figur 1 zeigt eine großflächige Solarzelle mit schleifenförmigen Überständen der Verbinder an den vorgesehenen Trennstellen.

Die Figuren 2 und 3 zeigen die aufgeteilte Solarzellenscheibe.

Die Figur 4 zeigt eine großflächige Solarzelle mit schuppenförmig angeordneten Verbinderteilstücken.

Figur 5 zeigt die Ausgestaltung aneinandergrenzender Verbinderteilstücke.

Die Figur 6 zeigt die Aufteilung der Solarzelle gemäß Figur 5 in Einzelsolarzellen.

In der Figur 1 ist eine großflächige Solarzelle 1 mit ihrer für den Lichteinfall vorgesehenen Oberflächenseite 2 dargestellt. Auf der nicht sichtbaren Zellenrückseite befindet sich der Rückseitenkontakt. Auf der Oberfläche 2 ist ein Leitbahnsystem 3 angeordnet, dessen Mittelstege, an die die Verbinder 6 angeschlossen werden, verbreitert sind. Die Verbinder 6 bestehen beispielsweise aus einem dünnen Metallband aus Aluminium, Kupfer oder versilbertem Kupfer. Diese Bänder haben eine Dicke von ca. 50 - 100 µm und eine Breite von 2 - 3 mm. Die Bänder werden an voneinander getrennten Stellen 4a und 4b mit dem Leitbahnsystem elektrisch leitend und mechanisch fest verbunden. Dies geschieht beispielsweise durch Löten, Kleben oder Schweißen. Bei dem in der Figur 1 dargestellten Ausführungsbeispiel ragen die Verbinder in entgegengesetzten Richtungen über den Scheibenrand hinaus und erheben sich an vorgesehenen Auftrennstellen zwischen den Verbindungsstellen 4a und 4b schleifenförmig über die Oberfläche der Solarzelle. Diese Schleife 5 wird beim Zerlegen der Halbleiterscheibe

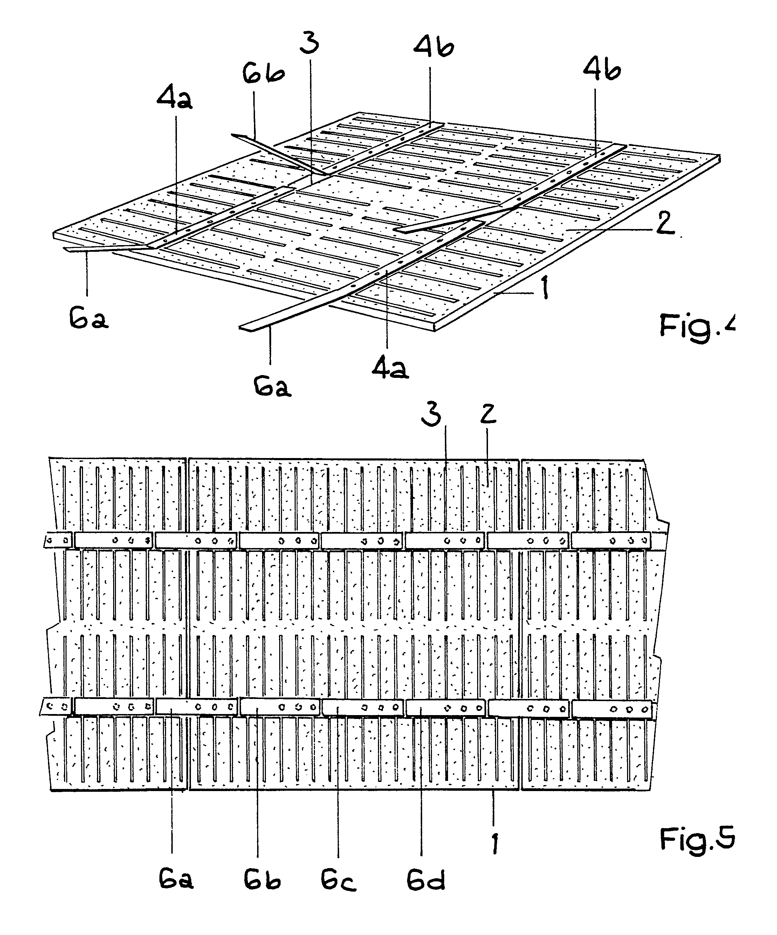

in einzelne Solarzellen 8 und 9 gemäß Figur 3 so aufgeschnitten, daß jede Solarzelle einen Verbinder 6a und 6b erhält, der sich über den Scheibenrand hinaus erstreckt und mit weiteren Solarzellen elektrisch leitend verbunden werden kann.

Die Solarzelle gemäß Figur 1 kann unzertrennt verwendet werden. In diesem Fall werden die Schleifen 5 vorzugsweise flachgedrückt. Die Solarzelle nach der Figur 1 kann aber auch in zwei Solarzellen gemäß Figur 2 oder in vier Solarzellen gemäß Figur 3 aufgeteilt werden. In jedem Fall ist bereits jede Solarzelle mit einem elektrischen Verbinder versehen.

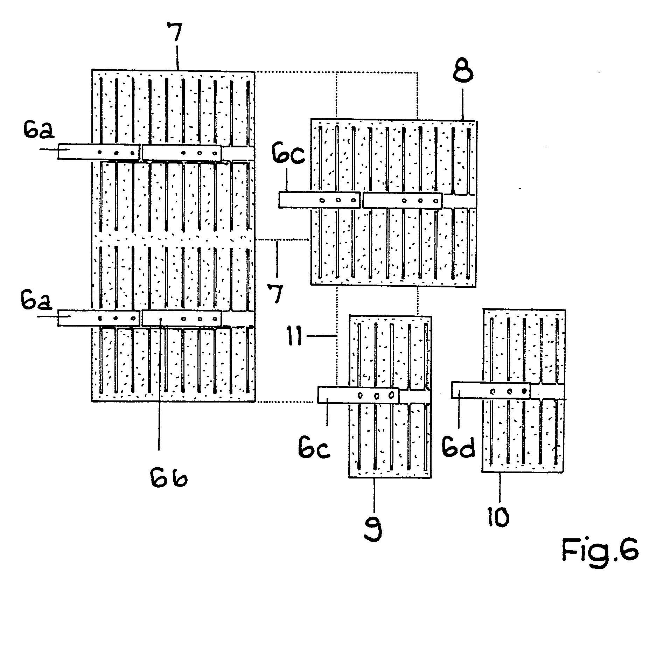

In Figur 4 ist eine Solarzelle dargestellt, in der jeder Verbinder 6 in Verbinderteilstücke 6a und 6b aufgeteilt ist. Jedes Verbinderteilstück ist an den Stellen 4a bzw. 4b mit dem Leitbahnsystem auf der Oberfläche 2 der Solarzelle elektrisch und mechanisch fest verbunden. Das freie Ende des Verbinderteilstückes 6b überlappt das Verbinderteilstück 6a schuppenförmig. In einer Reihe können selbstverständlich auch mehr als zwei Verbinderteilstücke liegen; die Zahl der Verbinderteilstücke richtet sich nach der Zahl der maximal aus einer Scheibe zu gewinnenden kleineren Solarzellen. Die Solarzelle gemäß Figur 4 kann nun an den Oberflächenstellen, an denen kein Verbinderteilstück fest mit dem Leitbahnsystem verbunden ist, durchgetrennt werden. Da es sich bei der Anordnung gemäß der Figur 4 um eine Solarzelle mit zwei parallelen Leitbahnstrukturen handelt, kann diese Zelle in maximal vier Einzelsolarzellen aufgeteilt werden, wobei jede einzelne Solarzelle dann mit einem über den Scheibenrand hinausragenden Verbinderteilstück 6a oder 6b versehen ist.

0115803

Bei der Anordnung gemäß Figur 5 werden die Verbinderteilstücke 6a und 6b gemäß Figur 4 durch jeweils vier
Verbinderteilstücke 6a bis 6d ersetzt, die sich jedoch
nicht überlappen. Das freie Ende jedes Verbinderteilstückes grenzt an das mit der Leitbahn fest verbundene
Ende des in der Reihe vorangehenden Verbinderteilstückes
an. Die Trennlinien 11 zum Aufteilen der Solarzelle sind
dann gemäß Figur 6 so zu legen, daß sie jeden einzelnen
Verbinder an der Stelle zwischen dem an dem Leitbahnsystem
befestigten und dem nichtbefestigten Teil schneidet. Eine
Solarzelle gemäß der Figur 5 kann somit bei dem dargestellten doppelten Leitbahnsystem in maximal acht Einzelsolarzellen 9 und 10 gemäß Figur 6 aufgeteilt werden. Es ist
jedoch auch eine Aufteilung der Solarzelle in vier
Einzelsolarzellen 8 oder in zwei Einzelsolarzellen 7
möglich. In jedem Aufteilungsfall ist jede einzelne
Solarzelle bereits mit einem oder mit zwei bandförmigen
Verbinder versehen, die über den Scheibenrand der
Solarzelle hinausragen und zum Anschluß an eine andere
Solarzelle, beispielsweise an den Rückseitenkontakt
der nachfolgenden Zelle im Solargenerator, dienen.

Die Anordnung gemäß den Figuren 5 und 6 kann zu einer
weiteren Rationalisierung des Herstellungsverfahrens
herangezogen werden. In diesem Fall werden die Verbinder
6a bis 6d vorzugsweise auf einer Folie befestigt. Diese
Folie wird sodann auf die Scheibenoberfläche aufgebracht
und die Verbinder 6a bis 6d werden an den vorgesehenen
Verbindungsstellen mit dem Leitbahnsystem der Solarzelle
verbunden. Beim Aufteilen der Solarzelle 1 in einzelne
Solarzellen 7 bis 10 bleibt die Ordnung der Solarzellen
zunächst erhalten, da die Verbinder weiterhin an der
verwendeten Hilfsfolie haften. Die einzelnen Solarzellen
können sodann von der Folie vollautomatisch abgearbeitet
werden. Eine derartige Folie wird vorzugsweise bandförmig aufgebaut, so daß, wie in Figur 5 angedeutet, in einer Reihe liegende Solarzellen in einem Fließbandprozeß mit der Folie, bzw. Teilstücken der Folie, an denen jeweils die metallischen Verbinder bereits anhaften, belegt werden können. Die Folie ist eine Klebefolie, vorzugsweise eine Selbstklebefolie, die an den Verbindungsstellen mit Öffnungen versehen werden muß, so daß dort der erforderliche Schweiß- oder Lötprozeß durchgeführt werden kann. Die Folie wird so auf die Halbleiterscheibe aufgebracht, daß die Verbinderteilstücke mit den metallischen Leitbahnen auf der Oberfläche der Solarzelle in Berührung gelangen.

TELEFUNKEN electronic GmbH
Theodor-Stern-Kai 1, 6000 Frankfurt 70   **0115803**

Heilbronn, den 18.01.83
PTL-HN-Ma-ra - HN 82/34


Patentansprüche


1) Scheibenförmige Solarzelle mit einem Rückseitenkontakt und mit Leitbahnen (3) auf der für den Lichteinfall vorgesehenen Oberflächenseite (2), an die zur
Verschaltung der Solarzelle mit weiteren Solarzellen
mindestens ein metallischer Verbinder (6) angeschlossen
ist, dadurch gekennzeichnet, daß der oder die Verbinder
(6) an mehreren, voneinander beabstandeten Stellen (4a,
4b) mit der oder den Leitbahnen (3) elektrisch leitend
und mechanisch fest derart verbunden sind, daß beim Aufteilen der Solarzelle in mehrere kleinere Solarzellen
(7 - 10) jede einzelne Solarzelle bereits mit mindestens
einem, über den Scheibenrand hinausragenden Verbinder
(6a - 6d) versehen ist.


2) Scheibenförmige Solarzelle nach Anspruch 1, dadurch
gekennzeichnet, daß zwischen den Verbindungsstellen -
gemessen am Abstand zwischen ihnen - überschüssiges,
bandförmiges Verbindermaterial (5) verbleibt.


3) Solarzelle nach Anspruch 1 oder 2, dadurch gekennzeichnet, daß an den Leitbahnen zahlreiche Verbinderteilstücke (6a, 6b) angebracht sind, die in einer Reihe
liegend angeordnet und nur mit einem Ende (4a, 4b) an
der Leitbahn befestigt sind, während das freistehende
Ende das in der Reihe vorangehende Verbinderteilstück
schuppenförmig überlappt.

4) Solarzelle nach Anspruch 1 oder 2, dadurch gekennzeichnet, daß an den Leitbahnen mehrere Verbinderteilstücke (6a - 6d) angebracht sind, die in einer Reihe liegend angeordnet und nur mit einem Ende an der Leitbahn befestigt sind, während das freistehende Ende an das in der Reihe vorangehende Verbinderteilstück angrenzt, ohne dieses zu überlappen.

5) Solarzelle nach Anspruch 3 oder 4, dadurch gekennzeichnet, daß die Schnittstellen (11) durch die Solarzellen derart gelegt werden, daß die einzelnen kleineren Solarzellen (1a - 1d) nach dem Zerteilen der Halbleiterscheibe jeweils mindestens einen, über den Rand der Scheibe hinausragenden, bandförmigen Verbinder (6c, 6d) aufweisen.

6) Solarzelle nach Anspruch 1 und 2, dadurch gekennzeichnet, daß die Verbinder oder Verbinderteilstücke auch zwischen den Verbindungsstellen zusammenhängend ausgebildet sind und zwischen diesen Verbindungsstellen auftrennbar sind.

7) Solarzelle nach Anspruch 6, dadurch gekennzeichnet, daß die Verbinder in entgegengesetzten Richtungen über den Scheibenrand hinausragen.

8) Solarzelle nach Anspruch 6 oder 7, dadurch gekennzeichnet, daß sich die Verbinder an den Auftrennstellen zwischen den Verbindungsstellen mit den Leitbahnen schleifenförmig (10) über die Oberfläche der Solarzelle erheben.

9) Verfahren zum Herstellen einer Solarzelle nach einem der vorangehenden Ansprüche, dadurch gekennzeichnet, daß die Verbinder oder Verbinderteilstücke auf einer Folie

0115803

befestigt werden, daß sie mit der Folie auf die Scheibenoberfläche aufgebracht und die Verbinder an den vorgesehenen Verbindungsstellen mit den Leitbahnen verbunden werden, daß die Scheibe danach in einzelne Solarzellen aufgeteilt wird, derart, daß die Ordnung der
einzelnen Solarzellen auch nach dem Zerteilen der
Scheibe durch die Haftung der Verbinder an der einheitlichen Folie erhalten bleibt.

10) Verfahren nach Anspruch 9, dadurch gekennzeichnet,
daß die Folie bandförmig ausgebildet ist und für die
Verbindung mit einer Vielzahl von Solarzellen vorgesehen ist.

11) Verfahren nach Anspruch 9 oder 10, dadurch gekennzeichnet, daß die Folie an vorgesehenen Verbindungsstellen mit Öffnungen versehen wird.

12) Verfahren nach einem der vorangehenden Ansprüche,
dadurch gekennzeichnet, daß Verbinder aus bandförmigem
Al, Ag, Cu oder versilbertem Cu verwendet werden und
daß diese Verbinder durch Löten, Kleben oder Schweißen
mit den Leitbahnen der Solarzelle verbunden werden.

Fig. 1

Fig. 2

Fig. 3

0115803

Fig.4

Fig.5

Fig.6